Europäisches Patentamt

(19) European Patent Office

Office européen des brevets

(11) Veröffentlichungsnummer: **0 114 238**

**A2**

(12) # EUROPÄISCHE PATENTANMELDUNG

(21) Anmeldenummer: **83111541.5**

(22) Anmeldetag: **18.11.83**

(51) Int. Cl.³: **H 04 B 9/00**

(30) Priorität: **21.01.83 DE 3301856**

(43) Veröffentlichungstag der Anmeldung:
**01.08.84 Patentblatt 84/31**

(84) Benannte Vertragsstaaten:
**AT CH DE FR GB IT LI NL SE**

(71) Anmelder: **Richard Hirschmann Radiotechnisches Werk**
**Richard-Hirschmann-Strasse 19**
**D-7300 Esslingen a.N.(DE)**

(72) Erfinder: **Ludolf, Wilhelm, Dr.-Ing.**
**Wilhelm-Röntgen-Strasse 40**
**D-7302 Ostfildern 1(DE)**

(72) Erfinder: **Schenkyr, Rainer, Dipl.-Ing.**
**Meisenweg 16**
**D-7050 Waiblingen(DE)**

(72) Erfinder: **Sommer, Rolf-Dieter, Dipl.-Ing.**
**Lonseerstrasse 9**
**D-7000 Stuttgart 61(DE)**

(74) Vertreter: **Stadler, Heinz, Dipl.-Ing.**
**Richard Hirschmann Radiotechnisches Werk**
**Richard-Hirschmann-Strasse 19**
**D-7300 Esslingen a.N.(DE)**

(54) **Endstufe eines optischen Senders für digitale Signalübertragung.**

(57) Bei einer Endstufe eines optischen Senders für digitale Signalübertragung liegt parallel zur Senderdiode (D) ein Shunt-Transistor ($T_S$) in Emitterschaltung, zwischen dessen Ein- und Ausgang ein Gegenkopplungsnetzwerk eingeschaltet ist.

Zur Vermeidung eines unerwünschten Speichereffektes durch Sättigung des Shunt-Transistors ($T_S$) unabhängig von dessen Kollektorstrom ist das Gegenkopplungsnetzwerk so ausgebildet, daß ein Absinken des Kollektorpotentials des Shunt-Transistors ($T_S$) unter einen einstellbaren über seiner Sättigungsspannung liegenden Wert durch Verringerung seines Basisstroms verhindert ist.

Eine besonders zweckmäßige Ausführung dieses Gegenkopplungsnetzwerks als Stromquelle besteht aus einem Transistor ($T_G$), dessen Basis an eine einstellbare Spannungsquelle ($U_{Ref}$) angeschlossen ist und der emitterseitig über einen Widerstand ($R_G$) mit dem Kollektor des Shunt-Transistors ($T_S$) sowie kollektorseitig mit dem nichtinvertierenden Eingang eines Vorverstärkers ($T_V$, $R_1$, $R_2$, $R_3$, $R_4$) verbunden ist, dessen Ausgang auf den Eingang des Shunt-Transistors ($T_S$) führt.

Fig.2

Richard Hirschmann
Radiotechnisches Werk
Richard-Hirschmann-Str. 19
7300 Esslingen a.N.

_ / _

18.1.1983
TPA/Stad/El

Patentanmeldung

## Endstufe eines optischen Senders für digitale Signalüber - tragung

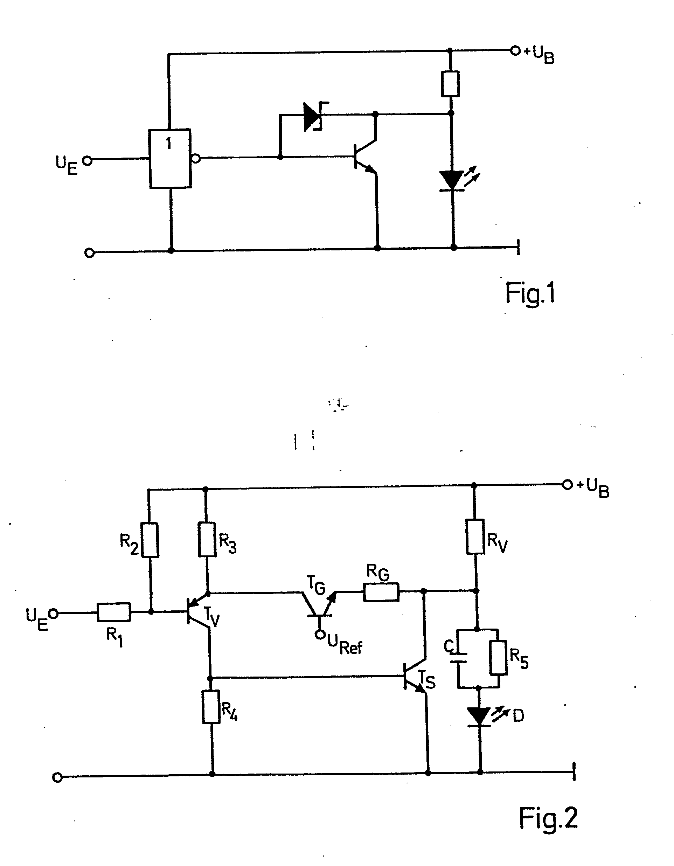

Die Erfindung betrifft eine Endstufe eines optischen Senders für digitale Signalübertragung, mit einem zur Senderdiode in Emitterschaltung parallel geschalteten Transistor (Shunt - Transistor) und einem zwischen dessen Ein- und Ausgang eingeschalteten Gegenkopplungsnetzwerk. Eine derartige, in Fig. 1 angegebene optische Senderendstufe ist z.B. von dem Experimentiersystem "OXE" der Anmelderin bekannt. Durch die Verwendung des Shunt-Transistors sind gegenüber dem ebenfalls bekannten Aufbau optischer Sender als geschaltete Stromquelle Strom - schwankungen während der Ein- und Ausschaltzeiten der Senderdiode (in der Praxis hauptsächlich LED) und damit Störsignale auf den Versorgungsleitungen vermieden; darüberhinaus ist damit ein einfacher Schaltungsaufbau und die Verwendung kleiner und schneller HF-Transistoren ermöglicht.

Bei einer Shunt-Schaltung ohne Gegenkopplung tritt durch Sätti- gung des Shunt-Transitors ($U_{CE}$ unterschreitet die Sättigungs - spannung $U_s$ = 0,3 V) ein unerwünschter Speichereffekt auf, da beim anschließenden Sperren des Shunt-Transistors zuerst die gespeicherten Ladungsträger ausgeräumt werden müssen, ehe die Kollektorspannung wieder ansteigt. Die Speicherzeit ist abhängig vom Basis- und Kollektorstrom und kann im ungünstigsten Fall mehrere Mikrosekunden betragen, sodaß im Extremfall bei ent - sprechend hohen Bitraten die Senderdiode überhaupt nicht mehr einschaltet. Zur Vermeidung dieses Effektes hat man zwischen Basis und Kollektor des Shunt - Transistors als Gegenkopplung eine Schottky - Diode vorgesehen. Da deren Durchlasspannung 0,3 V und die Basisspannung des Shunt-Transistors 0,7 V be - trägt, wird auf einfache Weise das Kollektorpotential des Shunt-Transistors auf einem Wert von ≳ 0,4 V gehalten, bei dem eine Sättigung mit Sicherheit ausgeschlossen ist.

Diese Schaltung ist indessen ohne weitere Maßnahmen nur bis zu Kollektorströmen von maximal etwa 30 mA verwendbar, weil bei höheren Kollektorströmen des Shunt-Transistors im Falle der Gegenkopplung der Spannungsabfall an der Schottky - Diode o,3V übersteigt und somit das Kollektorpotential unter o,4 V ab - sinkt und die Sättigungsspannung erreicht.

Für alle hochwertigen Übertragungssysteme, insbesondere für industrielle Anwendungen mit größeren Reichweiten werden je - doch Kollektorströme von > 50 mA benötigt, sodaß die bekannte Senderendstufe lediglich für einen sehr schmalen Anwendungsbe - reich geeignet ist.

Aufgabe der Erfindung ist es daher, eine Endstufe der eingangs genannten Art zu schaffen, bei der mit möglichst geringem Schaltungsaufwand eine Sättigung des Shunt-Transistors unabhängig vom Kollektorstrom wirksam vermieden ist.

Diese Aufgabe ist dadurch gelöst, daß das Gegenkopplungsnetz - werk so ausgebildet ist, daß ein Absinken des Kollektorpoten- tials des Shunt - Transistors unter einen einstellbaren, über seiner Sättigungsspannung liegenden Wert durch Verringerung seines Basisstroms verhindert ist. Das Kollektorpotential des Shunt - Transistors ist somit stets größer als seine Sättigungs- spannung, sodaß die optische Senderendstufe auf höchst einfache und kostensparende Weise sowohl bei niederen, als auch bei hohen Senderleistungen frei von Speichereffekten und damit auf der gesamten Breite der Anwendungsmöglichkeiten einsetzbar ist.

In den Unteransprüchen sind vorteilhafte Ausführungen bzw. eine vorteilhafte Ausgestaltung der Erfindung nach dem Hauptanspruch beschrieben.

Durch ein Gegenkopplungsnetzwerk gemäß Anspruch 2 arbeitet die erfindungsgemäße Endstufe unabhängig von der Größe der Versorgungsspannung und ist damit ohne Änderung von Schaltungsbauteilen z.B. im Bereich von 5 - 15 V universell für verschiedene Logikfamilien verwendbar.

Eine besonders einfache und zweckmäßige Ausführung einer solchen Stromquelle nach Anspruch 2 ist in Anspruch 3 angegeben, bei der die minimale Spannung am Kollektor des Shunt-Transistors durch das einstellbare Basispotential $(U_{Ref})$ mühelos und ohne großen Aufwand bestimmbar ist. Im Bedarfsfalle können selbstverständlich der Transistor $T_G$ und der Wider – stand $R_G$ durch einen geeigneten Operationsverstärker ersetzt sein.

Eine mit minimalem Aufwand ausgeführte Gegenkopplung ist dem Anspruch 4 zu entnehmen. Dabei ist allerdings in Kauf zu nehmen, daß für unterschiedliche Versorgungsspannungen jeweils eine Änderung der Bauteile oder ein zusätzlicher Schaltungsaufwand nötig ist.

Eine Schaltungsmaßnahme gemäß Anspruch 5 bewirkt eine Strom – überhöhung sowohl der ansteigenden als auch der abfallenden Flanken der Digitalsignale; auf diese Weise ist eine wesent – liche Verringerung der Schaltzeiten der Senderdiode und somit eine größere Übertragungskapazität erreicht.

Die Fig. 2 zeigt das Schaltbild eines Ausführungsbeispiels der erfindungsgemäßen optischen Senderendstufe.

Das digitale Eingangssignal gelangt vom Eingangsanschluß $U_E$ über einen einstufigen Vorverstärker $T_V$, $R_1$, $R_2$, $R_3$, $R_4$ und einen Shunt-Transistor $T_S$ in Emitterschaltung auf die dazu parallel liegende, als LED ausgebildete Senderdiode D, der zur Verkürzung der Schaltzeiten die Parallelschaltung eines Kondensators C und eines Widerstandes $R_S$ in Serie geschaltet ist. Die Kathode der Senderdiode D, sowie der Emitter des Shunt – Transistors $T_S$ sind mit Masse verbunden; dessen Kollektor (und damit der diodenferne Anschluß der Parallelschaltung C, $R_S$) ist einerseits über einen Vorwiderstand $R_V$ an den positiven Pol der Betriebsspannung + $U_B$ und zum anderen in einem Gegen – kopplungszweig über einen Widerstand $R_G$ an den Emitter eines Transistors $T_G$ angeschlossen, dessen Kollektor über die Emitter-Kollektorstrecke des Transistors $T_V$ des Vorverstärkers mit der Basis des Shunt-Transistors $T_s$ und dessen Basis mit einer Referenzspannungsquelle $U_{Ref}$ verbunden ist.

Der Widerstand $R_1$ des Vorverstärkers liegt zwischen dem Eingangsanschluß $U_E$ und der Basis des Transistors $T_V$; die Widerstände $R_2$ und $R_3$ verbinden dessen Basis bzw. Kollektor mit dem positiven Pol der Betriebsspannung $U_B$, der Widerstand $R_4$ seinen Kollektor mit Masse. Der Verstärkungsgrad des Vorverstärkers ist durch entsprechende Wahl des Verhältnisses der Widerstände $R_4/R_3$, der Signalhub des Digitalsignales an der Basis des Transistors $T_V$ durch entsprechende Größe der Widerstände $R_1$ und $R_2$ einstellbar.

Die Referenzspannung $U_{Ref}$ liegt um die Basis-Emitterspannung des Transistors $T_G$ über dem unteren Grenzwert der Kollektorspannung des Shunt-Transistors $T_s$.

Dieser Grenzwert ist somit durch entsprechende Wahl der Referenzspannung $U_{Ref}$ auf jeden gewünschten Wert (größer als die Sättigungsspannung des Shunt-Transistors $T_s$) einstellbar.

Solange die Kollektorspannung des Shunt-Transistors $T_s$ über dem eingestellten unteren Grenzwert liegt, ist die Gegenkopplung nicht wirksam. Erreicht die Kollektorspannung jedoch diesen unteren Grenzwert, so wird der Transistor $T_G$ leitend; der Strom durch diesen Transistor erhöht den Spannungsabfall am Widerstand $R_3$ und reduziert damit den Kollektorstrom des Transistors $T_V$ und somit auch den Basisstrom des Shunt-Transistors $T_s$. Mit Hilfe des Widerstandes $R_G$ ist der Verstärkungsgrad der Gegenkopplung einstellbar. Diese Gegenkopplung verhindert somit auf ebenso einfache wie wirkungsvolle Weise unabhängig vom Kollektorstrom des Shunt-Transistors $T_s$ dessen Sättigung. Außerdem arbeitet sie unabhängig von der Größe der Betriebsspannung $U_B$, da der Transistor $T_G$ eine Stromquelle darstellt.

Die Parallelschaltung C, $R_5$ bewirkt sowohl ein schnelles Einschalten, als auch Löschen der Sendediode D. Im Moment des Einschaltens ist der nur durch den Widerstand $R_V$ begrenzte Strom wirksam, in eingeschwungenem Zustand der Widerstand $R_V + R_S$. Durch die Größe dieser beiden Widerstände läßt sich somit neben der Höhe des Betriebsstromes der Grad der Stromüberhöhung, mit dem Wert der Kapazität C deren Dauer bestimmen.

Beim Ausschalten sinkt das Kollektorpotential des Shunt-Transistors $T_S$ rasch bis zum unteren Grenzwert ab, das Potential der Senderdiode sinkt im gleichen Maße ab und unterschreitet deren Flußspannung, wodurch ein schnelles Abklingen der Strahlung begünstigt wird. Durch diese Verkürzung der Schaltzeiten ist mit geringem Aufwand eine größere Übertragungsgeschwindigkeit bzw. eine höhere Bitrate des optischen Senders erreicht.

## Patentansprüche

1. Endstufe eines optischen Senders für digitale Signalübertragung, mit einem zur Senderdiode in Emitterschaltung parallel geschalteten Transistor (Shunt-Transistor) und einem zwischen dessen Ein- und Ausgang eingeschalteten Gegenkopplungsnetzwerk, dadurch gekennzeichnet, daß das Gegenkopplungsnetzwerk so ausgebildet ist, daß ein Absinken des Kollektorpotentials des Shunt-Transistors ($T_s$) unter einen einstellbaren, über seiner Sättigungsspannung liegenden Wert durch Verringerung seines Basisstroms verhindert ist.

2. Endstufe nach Anspruch 1, dadurch gekennzeichnet, daß das Gegenkopplungsnetzwerk eine Stromquelle ist, deren Strom proportional zu der Spannung ansteigt, um die das Kollektorpotential den eingestellten Wert unterschreitet.

3. Endstufe nach Anspruch 2, dadurch gekennzeichnet, daß die Stromquelle aus einem Transistor ($T_G$) besteht, der emitterseitig über einen Widerstand ($R_G$) mit dem Kollektor des Shunt-Transistors ($T_s$) und kollektorseitig mit dem nicht invertierenden Anschluß eines Vorverstärkers ($T_V$, $R_1$, $R_2$, $R_3$, $R_4$) verbunden ist, dessen Ausgang auf den Eingang des Shunt-Transistors ($T_s$) führt und daß die Basis des Transistors ($T_G$) an eine einstellbare Spannungsquelle ($U_{Ref}$) angeschlossen ist.

4. Endstufe nach Anspruch 1, dadurch gekennzeichnet, daß das Gegenkopplungsnetzwerk aus einer oder mehreren in Serie geschalteten Diode bzw. Dioden besteht, die einerseits an den Kollektor des Shunt-Transistors ($T_s$) und andererseits an den nicht invertierenden Anschluß eines ausgangsseitig mit dem Eingang des Shunt-Transistors ($T_s$) verbundenen Vorverstärkers angeschlossen ist bzw. sind.

5. Endstufe nach einem der Ansprüche 1 bis 4, dadurch gekennzeichnet, daß in Serie zur Senderdiode (D) die Parallelschaltung eines Widerstandes ($R_S$) und eines Kondensators
(C) eingeschaltet ist und die gesamte Shunt-Schaltung ($T_S$,
D, $R_S$, C) über einen Vorwiderstand ($R_V$) an der Versorgungsspannung ($U_B$) liegt.

Fig.1

Fig.2